# EUROPEAN PATENT APPLICATION

(11) **EP 4 821 743 A1**
(43) Date of publication of application: **14.10.2026**
(21) Application number: 25169822.1
(22) Date of filing: 10.04.2025
(51) Int. Cl.: B60L 53/10, B60L 53/66, H02J 7/00

(54) **METHOD FOR DETERMINING A CONNECTION CONFIGURATION OF A DC CHARGING SYSTEM, AND DC CHARGING SYSTEM**

(71) Applicant: ABB E-mobility B.V., 2629 JG Delft (NL)
(72) Inventor: BECH, Lars, 3119 JA Schiedam (NL); RAAIJMAKERS, Stefan, 2613 WN Delft (NL); LA ROSA, Cristoforo, 52025 Montevarchi (IT)
(74) Representative: Zimmermann & Partner Patentanwälte mbB

(57) **Abstract**

A method for determining a connection configuration of a DC charging system (100), and a DC charging system (100) including a configuration controller to determine the connection configuration, are provided. The DC charging system (100) includes a first primary-side terminal (UUF1) connectible to a first power module (PM1) of a DC power supply (PU); a second primary-side terminal (UUF2) connectible to a second power module (PM2) of the DC power supply (PU); a switch system (S1, S2, S3, S4) being operable to select between an open position to disconnect the first primary-side terminal (UUF1) from the first secondary-side vehicle connection terminal (UUS1) and a first single-supply position to connect the first primary-side terminal (UUF1) to the first secondary-side vehicle connection terminal (UUS1); a first insulation monitoring device (IMD1) provided to the first secondary-side vehicle connection terminal (UUS1); a first secondary-side voltage detector (V1) directly provided to the first insulation monitoring device (IMD1); and a first primary-side voltage detector (V2, V3) directly provided to the first power module (PM1). The method, e.g. performed at least in part by the configuration controller, includes: operating the first insulation monitoring device to apply a common mode voltage at a positive DC pole (UUS1+) and/or at a negative DC pole (UUS1-) of the first vehicle connection terminal (UUS1), or operating the first power module (PM1) to apply a voltage at the first primary-side terminal (UUF1); operating the switch system (S1, S2, S3, S4) in a sequence between the open position and the first single-supply position, and in each switch position, detecting a voltage with each of the first secondary-side voltage detector (V1) and the first primary-side voltage detector (V2, V3); and determining the connection configuration from the detected voltages.

## Description

### TECHNICAL FIELD

Embodiments of the present disclosure generally relate to the field of DC charging systems, e.g. DC charging systems for electrical vehicles.

### BACKGROUND

In electric vehicle charging systems, electrical power is provided in an electrical distribution grid onto which electric vehicle chargers are connected. Electric vehicles can thus connect to the electric vehicle chargers and draw power therefrom to recharge batteries mounted onto the electric vehicles. For example, a power unit (PU) includes one or more power modules (PM) for supplying DC electrical power to one or more DC charging units, or user units (UU). The DC charging unit may comprise one or more charging connection terminals, such as vehicle connection terminals, for supplying an object to be charged (e.g., an electrical vehicle) with DC charging power.

Because the voltage transferred as DC charging power may be quite high, e.g. 1000 Volts (V) DC or more, some conventional DC charging units are provided, at their charging connection terminal, with an insulation monitoring device (IMD) that monitors whether the DC charging unit is configured as intended regarding the insulation. For example, EP 4 378 046 A1 describes a forced symmetry IMD and a method to control the forced symmetry IMD, wherein one or more IMD power sources of a forced symmetry IMD is configured to control a common voltage on a common node based on a currently detected common voltage and a reference voltage signal.

However, there are more types configurations of interest other than the insulation configuration, e.g. a connection configuration of the DC charging unit or units in the DC charging system.

### SUMMARY OF THE DISCLOSURE

According to an aspect, a method for determining a connection configuration of a DC charging system is provided. The DC charging system includes a DC charging unit, a first insulation monitoring device (IMD), a first secondary-side voltage detector, and a first primary-side voltage detector. The DC charging unit includes a first primary-side terminal, a first secondary-side vehicle connection terminal, and a switch system. The first primary-side terminal is connectible or connected to a first power module of a DC power supply. The first secondary-side vehicle connection terminal is connectible or connected to a vehicle for providing vehicle charging power. The first IMD is provided, e.g. connected, to the first secondary-side vehicle connection terminal. The first secondary-side voltage detector is directly provided, e.g. directly connected, to the first insulation monitoring device. The first primary-side voltage detector is directly provided, e.g. directly connected, to the first power module. The switch system is operable to select between an open position and a first single-supply position. In the open position, the first primary-side terminal is disconnected from the first secondary-side vehicle connection terminal. In the first single-supply position, the first primary-side terminal is connected to the first secondary-side vehicle connection terminal. The method includes operating the first insulation monitoring device to apply a common mode voltage at a positive DC pole and/or a negative DC pole of the first vehicle connection terminal. Alternatively, the method includes operating the first power module to apply a voltage at the first primary-side terminal. The method further includes operating the switch system in a sequence between the open position and the first single-supply position, and, in each switch position, detecting a voltage with each of the first secondary-side voltage detector and the first primary-side voltage detector. The method further includes determining the connection configuration from the detected voltages.

According to another aspect, a DC charging system includes at least one DC charging unit, a first insulation monitoring device (IMD), a first secondary-side voltage detector, a first primary-side voltage detector, and a configuration controller. The DC charging unit includes a first primary-side terminal, a first secondary-side vehicle connection terminal, and a switch system. The first primary-side terminal is connectible or connected to a first power module of a DC power supply. The first secondary-side vehicle connection terminal is connectible or connected to a vehicle for providing vehicle charging power. The first IMD is provided, e.g. connected, to the first secondary-side vehicle connection terminal. The first secondary-side voltage detector is directly provided, e.g. directly connected, to the first insulation monitoring device.

The first primary-side voltage detector is directly provided, e.g. directly connected, to the first power module. The switch system is operable to select between an open position and a first single-supply position. In the open position, the first primary-side terminal is disconnected from the first secondary-side vehicle connection terminal. In the first single-supply position, the first primary-side terminal is connected to the first secondary-side vehicle connection terminal. The configuration controller is configured to perform a method as described herein. For example, the configuration controller is configured to operate the first insulation monitoring device to apply a common mode voltage at a positive DC pole and/or a negative DC pole of the first vehicle connection terminal. Alternatively, the configuration controller is configured to operate the first power module to apply a voltage at the first primary-side terminal. The configuration controller is further configured to operate the switch system in a sequence between the open position and the first single-supply position, and, in each switch position, detect a voltage with each of the first secondary-side voltage detector and the first primary-side voltage detector. The configuration controller is further configured to determining the connection configuration from the detected voltages.

In an embodiment, a charging infrastructure includes at least one DC charging system as described herein. The charging infrastructure further includes the DC power supply as described herein. The DC power supply comprises the first and second power modules.

In an embodiment, the charging infrastructure includes two or more DC charging units. The DC charging units are interconnected via one or more secondary-side DC power sharing terminals.

According to yet another aspect, a computer system is provided. The computer system includes a memory and a processor. The memory is configured to store program code. The processor is configured to execute the program code, e.g. after having read the program code from the memory, to implement a a method for determining a connection configuration of a DC charging system. The DC charging system includes a DC charging unit, a first insulation monitoring device (IMD), a first secondary-side voltage detector, and a first primary-side voltage detector. The DC charging unit includes a first primary-side terminal, a first secondary-side vehicle connection terminal, and a switch system. The first primary-side terminal is connectible or connected to a first power module of a DC power supply. The first secondary-side vehicle connection terminal is connectible or connected to a vehicle for providing vehicle charging power. The first IMD is provided, e.g. connected, to the first secondary-side vehicle connection terminal. The first secondary-side voltage detector is directly provided, e.g. directly connected, to the first insulation monitoring device. The first primary-side voltage detector is directly provided, e.g. directly connected, to the first power module. The switch system is operable to select between an open position and a first single-supply position. In the open position, the first primary-side terminal is disconnected from the first secondary-side vehicle connection terminal. In the first single-supply position, the first primary-side terminal is connected to the first secondary-side vehicle connection terminal. The method includes operating the first insulation monitoring device to apply a common mode voltage at a positive DC pole and/or a negative DC pole of the first vehicle connection terminal. Alternatively, the method includes operating the first power module to apply a voltage at the first primary-side terminal. The method further includes operating the switch system in a sequence between the open position and the first single-supply position, and, in each switch position, detecting a voltage with each of the first secondary-side voltage detector and the first primary-side voltage detector. The method further includes determining the connection configuration from the detected voltages.

### BRIEF DESCRIPTION OF THE DRAWINGS

Fig. 1 shows a schematic diagram of an exemplary DC charging infrastructure including a DC charging system.
Fig. 2 shows a flow chart of an exemplary method.
Fig. 3 shows a schematic diagram of an exemplary DC charging infrastructure including a DC charging system.
Fig. 4 shows a schematic diagram of an exemplary DC charging infrastructure including a DC charging system.
Fig. 5 shows a schematic diagram of an exemplary DC charging infrastructure including a DC charging system.
Fig. 6 shows a schematic diagram of an exemplary DC charging infrastructure including a DC charging system.
Fig. 7 shows a hardware configuration of a computer system.

### DETAILED DESCRIPTION

Technology is described hereinafter with reference to the figures, in which aspects exemplary embodiments are shown.

The claimed invention may, however, be embodied in different forms and should not be construed as being limited to the embodiments set forth herein. Like reference numerals refer to like elements throughout. Like elements will, thus, not be described in detail with respect to the description of each figure. It should also be noted that the figures are only intended to facilitate the description of the embodiments. They are not intended as an exhaustive description of the claimed invention or as a limitation on the scope of the claimed invention. In addition, an illustrated embodiment needs not have all the aspects or advantages shown. An aspect or an advantage described in conjunction with a particular embodiment aspect is not necessarily limited to that embodiment aspect and can be practiced in any other embodiments aspects even if not so illustrated, or if not so explicitly described. The features, functions, and advantages may be achieved independently in various embodiments manners or may be combined in yet other embodiments.

Before describing exemplary embodiments aspects illustratively depicted in the several figures, a general introduction is provided to further understanding.

DC charging power at a charging site, for example in a charging station for electric vehicles (EV), is distributed to the power outlets on site. A DC charging system, such as a DC charging system configured for charging the EV, typically includes at least one power unit and at least one vehicle charging unit. That is, the power unit is located at a distance from the power outlets, and is connected, via a DC link or DC cable, to the vehicle charging unit, or user unit, in which the power outlets are located.

The DC charging system may have a modular configuration. For example, a power unit may be combined with multiple (e.g., two or more) vehicle charging unit; or multiple power units (e.g., two or more) may be combined with one vehicle charging unit; or multiple power units (e.g., two or more) may be combined with multiple (e.g., two or more) vehicle charging units. In each case, the vehicle charging unit(s) must be properly wired to the power unit(s). There is a desire to detect a configuration, e.g., detect a combination of power unit(s) and vehicle charging unit(s) and/or detect whether a proper configuration or a misconfiguration, e.g. a miswiring and/or a wiring/PE fault, is present.

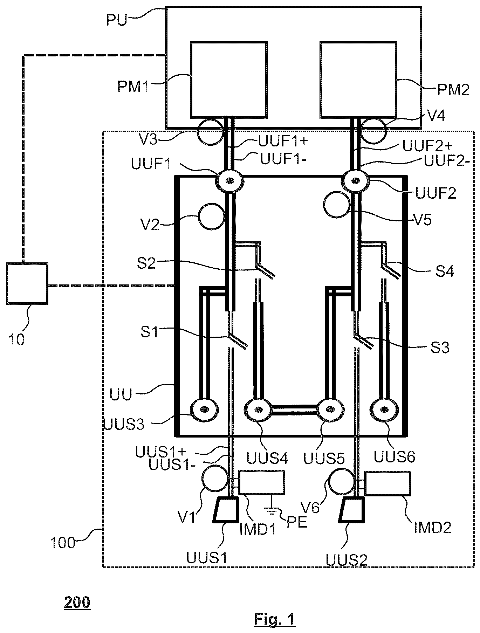

Fig. 1 shows a schematic diagram of an exemplary DC charging infrastructure 200 including a DC charging system 100. A power unit PU includes a first power module PM1 and a second power module PM2. Note that the disclosure is not limited to two power modules PM1, PM2, and it may also include one single power module, or it may include more than two power modules.

A power unit, as used herein, is typically a device that is connected to a power grid, such as a public AC grid. A typical power unit is configured to receive, at its primary side, AC power from the AC grid, convert it into DC power, and output the DC power, and/or vice-versa. The power unit typically includes power electronics. Typically, the power unit is installed at a location where the surrounding conditions are favorable, such as accessibility of the power grid, connectivity to the power grid, available space, cooling conditions etc. The power unit is typically located at a certain distance to the site where the vehicle is to be charged, e.g. a parking lot, and where the surrounding conditions for positioning the power unit would not be as favorable.

For example, but without limitation each power module, e.g. power module PM1 and power module PM2, each has a rated power of 100 kW.

A DC charging unit, or user unit UU, serves as an intermediary unit, or interface unit, between the power unit PU and a device to be charged/discharged, e.g. a vehicle. The side of the DC charging unit UU providing an interface to the power unit PU is referred to as the primary side of the DC charging unit UU, and the side of the DC charging unit UU providing an interface to the device to be charged/discharged is referred to as the secondary side of the DC charging unit UU.

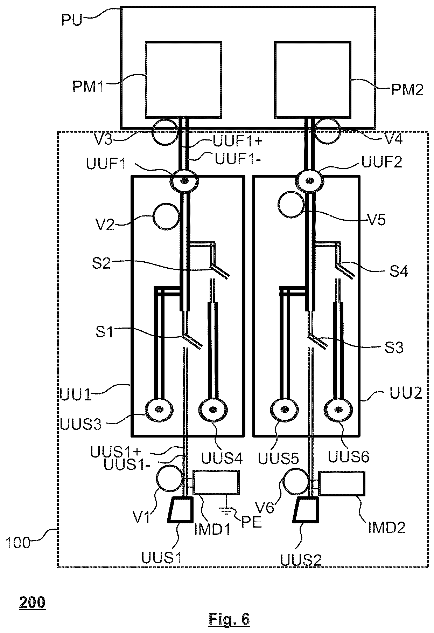

The DC charging unit UU is connectible, via a first primary-side terminal UUF1 and a second primary-side terminal UUF2, to the first and second power modules PM1, PM2. Note that the DC charging unit UU may also be configured to have only one primary-side terminal, or it may be configured to have more than two primary-side terminals. Moreover, the present disclosure is not limited to one single DC charging unit UU only (cf. e.g. Fig. 6 including a first DC charging unit UU1 and a second DC charging unit UU2). The DC charging unit is typically located at a certain distance from the power unit PU.

A primary-side DC terminal, as used herein, is typically any kind of connectivity-establishing or connectivity-enabling means that makes the reception of the first input current possible. This may include a plug/socket connection, but hard-wiring of the primary-side terminal is also possible. A connection to the output side of the power unit PU can be established via the primary-side terminal to receive the power output by the power unit PU, i.e. a current at a certain voltage.

The DC charging unit UU includes at least a first secondary-side vehicle connection terminal UUS1. The first secondary-side vehicle connection terminal UUS1 is connectible to a vehicle for providing charging power and/or for receiving power from the vehicle. The DC charging unit UU may include a second secondary-side vehicle connection terminal UUS2 connectible to a vehicle for providing charging power and/or for receiving power from the vehicle. The vehicle connectible to the first secondary-side vehicle connection terminal UUS1 may be different from the vehicle connectible to the second secondary-side vehicle connection terminal UUS2.

A secondary-side DC vehicle connection terminal, as used herein, is typically any kind of connectivity-establishing or connectivity-enabling means that makes the reception of the vehicle charging current possible, and typically includes a plug/socket connection.

Charging, as used herein, is understood as an illustrative rather than a restrictive term. Charging may include a flow of power (a current flow) in either a direction from the distribution unit towards a vehicle connected to a respective secondary-side DC vehicle connection terminal, or a direction from the secondary-side DC vehicle connection terminal towards the distribution unit. Moreover, charging may also include a supply of electrical power to the vehicle that is used for purposes other than raising the state of charge (SoC) of the vehicle's batteries, e.g. power consumed by on-board equipment. Furthermore, charging may include a supply of electrical power to the vehicle that is only indirectly used for raising the SoC of the batteries.

The DC charging unit UU further includes a switch system including switches S1, S2, S3, S4. The switch system is operable to select at least an open position to disconnect the first primary-side terminal UUF1 from the first secondary-side vehicle connection terminal UUS1, and a first single-supply position to connect the first primary-side terminal UUF1 to the first secondary-side vehicle connection terminal UUS1. Note that the switch system need not necessarily include four switches S1, S2, S3, S4, as exemplified in Fig. 1, and may include at least one switch, e.g. switch S1. For example, the switch system includes switch S1 that may be opened and closed according to a switch selection signal from a configuration controller 10. For convenience, the configuration controller 10 is only depicted in Fig. 1, and it is omitted in the following drawings. In the case that the switch system includes more than one switch, e.g. switches S1 through S4, each switch may be opened and closed according to the switch selection signal from the configuration controller 10. By selectively opening and closing the switch(es) of the switch system, the various switch positions, as described herein, may be selected, i.e. established.

A switch, as used herein, may be any kind of device that may safely connect and interrupt the respective current path, and is configured to transition between an ON state (a conducting state) and an OFF state (an interrupting state). Typically, transitioning between the ON and OFF states may be controlled such that it is performed automatically. An example of a switch includes a switch, or interrupter, or separator, or contactor, each having physical contacts. Another example of a switch includes a semiconductor element, such as a (power) MOSFET (metal oxide semiconductor field effect transistor), an IGBT (insulated gate bipolar transistor), and the like.

The DC charging system 100 further includes a first insulation monitoring device IMD1. The first insulation monitoring device IMD1 is provided, e.g. connected, to the first secondary-side vehicle connection terminal UUS1. Note that the IMD1 may be connected internally or externally to the first secondary-side vehicle connection terminal. The DC charging system 100 further includes a first secondary-side voltage detector V1. The first secondary-side voltage detector V1 is directly provided, e.g. directly connected, to the first insulation monitoring device IMD1. The DC charging system 100 further includes a first primary-side voltage detector V2, V3. The first primary-side voltage detector V2, V3 is directly provided, e.g. directly connected, to the first power module PM1.

A device that is provided to a target element, as used herein, indicates that the functionality achieved by the corresponding device and described herein, is exerted on the corresponding target element, e.g. has an immediate effect on the corresponding target element. For example, the first insulation monitoring device IMD1 being provided to the first secondary-side vehicle connection terminal UUS1 means that the insulation monitoring functionality of the first insulation monitoring device IMD1 is exerted on the first secondary-side vehicle connection terminal UUS1. In some or all cases, providing the device to the target element may be achieved by electrically connecting, e.g. galvanically connecting, the device and the target element.

A device that is directly provided to a target element, as used herein, indicates that the functionality achieved by the corresponding device and described herein, is exerted on the corresponding target element without intermediation of another functional element, e.g. has an immediate effect on the corresponding target element without being substantially influenced by the another functional element. In some examples, any such another functional element may be e.g. the switch system or a part of the switch system.

A device that is directly connected to a target element, as used herein, indicates that the functionality achieved by the corresponding device and described herein, is exerted on the corresponding target element by way of an electrical connection, e.g. a galvanic connection, without intermediation of another functional element, e.g. has an immediate effect on the corresponding target element without being substantially influenced by the another functional element. In some examples, any such another functional element may be e.g. the switch system or a part of the switch system.

The insulation monitoring devices described herein, e.g. the first insulation monitoring device IMD1, may be configured as described e.g. in EP 4 378 046 A1. For example, the DC charging system 100 includes IMD1 to detect a first fault to earth via an earth leakage detection. IMD1 is configured such that it may apply a common mode voltage at a positive DC pole UUS1+ and/or a negative DC pole UUS1- of the first vehicle connection terminal UUS1.

In an example, the first insulation monitoring device IMD1 is operated such that a common mode voltage is applied at the positive DC pole UUS1+ and/or the negative DC pole UUS1- of the first vehicle connection terminal UUS1. Applied to the positive DC pole UUS1+ and/or the negative DC pole UUS1-, as used herein, does not necessarily mean that the IMD1 is directly connected to the respective pole or poles; however, the IMD1 exerts the common mode voltage such that it acts on the positive DC pole UUS1+ and/or the negative DC pole UUS1-. In an example, however, the IMD1 is connected to the respective pole or poles. Alternatively, the first power module PM1 is operated to apply a voltage at the first primary-side terminal UUF1. When the respective voltage is applied via IMD1 or PM1, the switch system is operated in a sequence between the open position and the first single-supply position. In each of these switch positions, a voltage is detected with each of the first secondary-side voltage detector V1 and the first primary-side voltage detector V2, V3. From the detected voltages, the connection configuration is determined.

The connection configuration, as used herein, may include an information as to whether the connection from the first power module PM1 to the first primary-side terminal UUF1 is correct. In this sense, the detected connection configuration is equivalent to a self-test. Additionally, or alternatively, the connection configuration, as used herein, may include an information about a connection topology, possibly including further power modules (e.g. a second power module PM2 and/or a third power module PM3, to be described later in more detail) and/or further secondary-side vehicle connection terminals (e.g. a second secondary-side vehicle connection terminal UUS2, possibly included in another DC charging unit UU2, to be described later in more detail).

In an example, the DC charging unit UU further includes a second primary-side terminal UUF2 connectible to a second power module PM2 of the DC power supply PU. In this example, the switch system is further operable to select - in addition to the selectable positions described above - a first double-supply position to connect both the first and second primary-side terminals UUF1, UUF2 to the first secondary-side vehicle connection terminal. In this example, the switch system is operated in a sequence between the open position, the first single-supply position, and the first double-supply position. In each of these switch positions, a voltage is detected with each of the first secondary-side voltage detector V1 and the first primary-side voltage detector V2, V3. From the detected voltages, the connection configuration is determined. Here, the open position includes a position in which the primary-side terminals UUF1, UUF2 are disconnected from the secondary-side vehicle connection terminals UUS1, UUS2.

In an example, when the DC charging unit UU further includes the second primary-side terminal UUF2 as described above, the DC charging unit UU further includes a second primary-side voltage detector V4, V5 directly provided, e.g. connected, to the second power module PM2. The second primary-side voltage detector V4, V5 is configured to measure a voltage at the second power module PM2, e.g. an output voltage of the second power module.

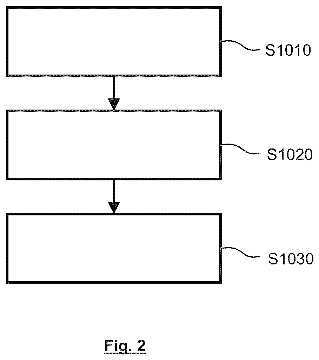

At least part of the operation and/or determining, as described herein, may be performed by the configuration controller 10. For example, the configuration controller 10 may perform a method as shown in a flow chart of Fig. 2. For example, referring to Fig. 2, the configuration controller 10 may operate, in S1010, the first insulation monitoring device to apply a common mode voltage at the positive DC pole UUS1+ and/or at the negative DC pole UUS1- of the first vehicle connection terminal UUS1, or operate the first power module PM1 to apply a voltage at the first primary-side terminal UUF1; operate, in S1020, the switch system S1, S2, S3, S4 in a sequence between the open position and the first single-supply position, and in each switch position, detect a voltage with each of the first secondary-side voltage detector V1 and the first primary-side voltage detector V2, V3; and determine, in S1030, the connection configuration from the detected voltages.

Referring back to Fig. 1, in the variant in which the common mode voltage is applied via the first insulation monitoring device, in the open position of the switch system, it is expected that both a DC+/PE voltage and a DC-/PE voltage can be detected, or measured, via the first secondary-side voltage detector V1. Note that PE is "protective earth", DC+ is the positive DC voltage of the common mode voltage applied via IMD1, and DC- is the positive DC voltage of the common mode voltage applied via IMD1. IMD1 supplies a safe voltage to DC+ and PE (the DC+/PE voltage) and a safe voltage to DC- and PE (the DC-/PE voltage). That is, enabling IMD1 should only result in a voltage at V1. If there is a voltage at V2, V3, or possibly other points, then there is either a contactor failure or a wiring mistake.

In the first single-supply position of the switch system, it is expected that the both DC+/PE voltage and the DC-/PE voltage can be detected, or measured, via the first primary-side voltage detector V2, V3.

In the variant in which the first power module PM1 applies the voltage at the first primary-side terminal UUF1, PM1 is preferably operated to supply a safe voltage, e.g. a low voltage similar to IMD1. Here, in the open position of the switch system, it is expected that a voltage is only measured at V2, V3, and in the first single-supply position, a voltage is measured at V1, V2, V3.

In an example, the DC charging unit UU includes a first secondary-side DC power sharing terminal UUS4 and a second secondary-side DC power sharing terminal UUS5. The configuration may also be such that the first secondary-side DC power sharing terminal UUS4 is located in a first user unit UU1, and the second secondary-side DC power sharing terminal UUS5 is located in a second user unit UU2, as shown e.g. in Fig. 6. In an example, the second secondary-side power sharing terminals UUS4, UUS5 are connected, e.g. internally connected as in Fig. 1 or externally connected as possible in the configuration shown in Fig. 6. A cascading of DC charging units UU is possible via the secondary-side power sharing terminals. For example, the DC charging unit further includes a third secondary-side power sharing terminal UUS3 and a fourth secondary-side power sharing terminal UUS6. That is, each second secondary-side power sharing terminal is connectible to yet another charging distribution unit. In this way, input power can be obtained from the second secondary-side power sharing terminal, i.e. from the yet another charging distribution unit. This enables a cascading of distribution units for power exchange on the secondary side thereof.

A secondary-side DC power sharing terminal, as used herein, is typically any kind of connectivity-establishing or connectivity-enabling means that makes the reception of the vehicle charging current possible, and may include a plug/socket connection or a hardwired connection.

In an example, the connection of the first power module PM1 and the first primary-side terminal UUF1 is established via a first supply line UUF1+, UUF1-. The first primary-side voltage detector V3 is arranged, at the first supply line, on the side of the power module, and a third primary-side voltage detector V2 is arranged, at the first supply line, on the side of the DC charging unit UU. In other words: The first primary-side voltage detector V3 is located at the power module PM1, and the third primary-side voltage detector V2 is located at the DC charging unit UU. In this exemplary configuration, in addition to the configuration detectible via the procedure described above, a connection configuration regarding the first supply line UUF1+, UUF1- can be further detected, such as a connection fault in the first supply line UUF1+, UUF1-.

In an example, the DC charging system further comprises a second supply line UUF2+, UUF2-between the second power module PM2 and the second primary-side terminal UUF2. The second primary-side voltage detector V4 is arranged on a power module side of the second supply line. The DC charging system further comprises a fourth primary-side voltage detector V5 arranged on a DC charging unit side of the second supply line to measure a voltage supplied to or from the DC charging unit UU. In this exemplary configuration, in each switch position, additionally to the detection operations described above, a voltage is detected via the fourth primary-side voltage detector V5.

Here, in the first double-supply position, it is expected to measure the DC+/PE voltage on V1, V2, V3, V4, V5, and it is expected to measure the DC-/PE voltage on V1, V2, V3, V4, V5.

In an example, the switches S1, S2, S3, S4 of the switch system are initially in an open position, and then closed in a sequence of S1, S2, S3, S4. From measuring the voltage on V1, V2, V3, V4, V5 (e.g., the DC+/PE voltage), and measuring the voltage on V1, V2, V3, V4, V5 (e.g., the DC-/PE), it can be judged how the system is configured.

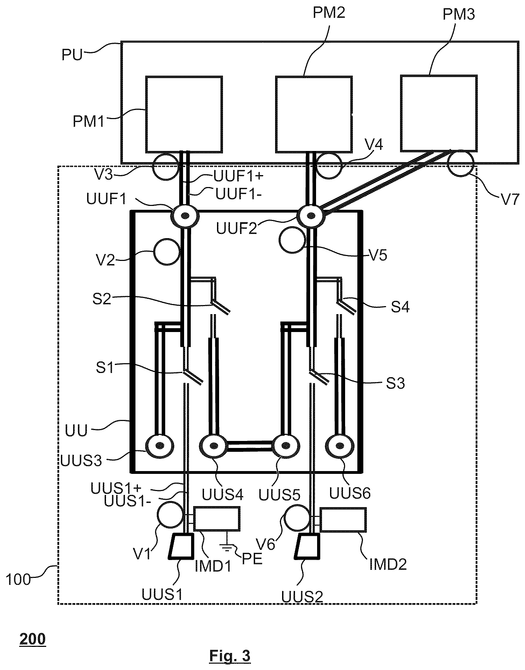

Fig. 3 shows a configuration in which a third power module PM3 is connected to the same point as the second power module PM2, i.e. the second primary-side terminal UUF2. At the third power module PM3, a third primary-side voltage detector V7 is arranged. The connection configuration shown in Fig. 3 may be determined by including a measurement of the voltage at the third primary-side voltage detector V7. That is, if e.g. PM2 is turned on, and V7 and V5 measure the same voltage or a similar voltage, it can be judged that PM2, PM3 are connected to the same point.

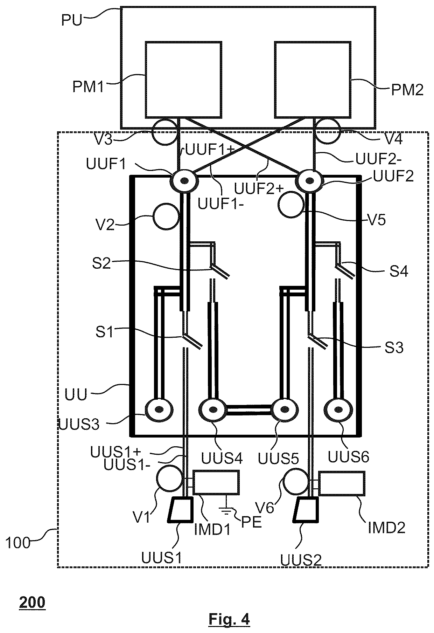

Fig. 4 shows a configuration including a wiring error. Namely, the wiring of the first and second supply lines UUF1+, UUF1-, UUF2+, UUF2-, has been partially swapped (wrong wire to the wrong power module). The common mode voltage measurements will identify which wire is wrongly connected. For example, when S1 is closed, a voltage will also be measured at V4, and only one voltage (DC+/PE) will be measured at V3, which is not as expected. Thus, when determining the connection configuration, it will be determined that the connection is erroneous.

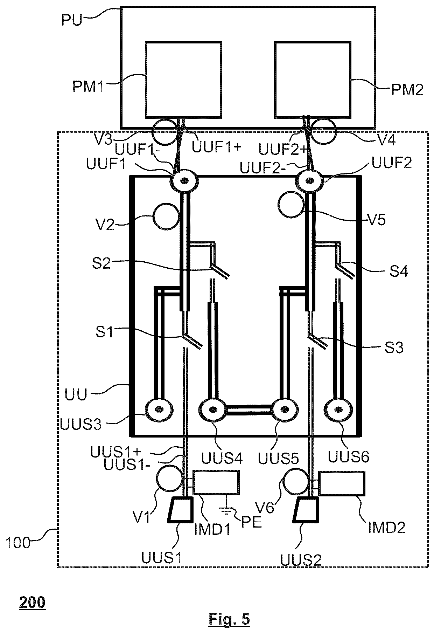

Fig. 5 shows a configuration including a wiring error. Namely, in the wiring of the first supply line UUF1+, UUF1-, the poles (DC+, DC-) have been switched. Likewise, in the wiring of the second supply line UUF2+, UUF2-, the poles (DC+, DC-) have been switched. Consequently, the common mode voltage measurements will measure inverted signals. Thus, when determining the connection configuration, it will be determined that the connection is erroneous. That is, it may be detected whether the connection configuration is a primary-side pole swapped connection.

In a variant of this type of wiring error, when e.g. the protective earth, PE, connection is missing, this will result in common mode differences, and will be detected in the common mode measurements. That is, it may be detected whether the connection configuration is a missing ground connection.

In an example, the DC charging unit UU further includes the second secondary-side vehicle connection terminal UUS2 connectible to a vehicle for providing vehicle charging power, the DC charging system further comprises a second insulation monitoring device IMD2 provided to the second secondary-side vehicle connection terminal UUS2, and a second secondary-side voltage detector V6 to measure a voltage supplied to or from the second insulation monitoring device IMD2. Here, the second insulation monitoring device IMD2 is operated such that it applies a common mode voltage at a positive DC pole and/or at a negative DC pole of the second secondary-side vehicle connection terminal UUS2. Then, in each switch position, in addition to the measurements above, a voltage is detected with the second secondary-side voltage detector V6.

In an example, in case the power module (e.g., voltage detector V3) cannot measure a common mode voltage, or e.g. IMD1 is not strong enough to drive a voltage on any of V3 or V4, e.g. due to a high capacitance, resistance, etc., another approach may be used. In a first step, power module PM1 is turned on such that it supplies a voltage, and the switches are in the open position. Here, it is expected to measure both the DC+/PE voltage on V2, V3, and the DC-/PE voltage on V2, V3. In the case that a voltage is also measured at other places (such as V1, V4, V5), then there is either a wiring issue or a broken contactor (which may be visible on the common mode side like V1, V5, V6). If the voltages are negative (swapped), then the wires are swapped. In a second step, S2 is closed. Here, it is expected to measure both the DC+/PE voltage on V2, V3, V4, V5, and the DC-/PE voltage on V2, V3, V4, V5. In the case that PM1 can supply a safe voltage, in a next step, S1 can be closed. Alternatively, PM1 may be turned off, and IMD1 may be used, and the voltages may be measured.

Fig. 6 shows an example in which a first user unit UU1 and a second user unit UU2 are supplied each via a distinct power module PM1/PM2. Also in this case, e.g. wiring errors may be detected via the technology described herein.

In the examples above, e.g. Fig. 1 shows a correct connection. For example, the correct connection is determined as the connection configuration when in the open position of the switch, a voltage is only detected by the first secondary-side voltage detector V1, and in the first single-supply position, a voltage is only detected by the first secondary-side voltage detector V1 and the first primary-side voltage detector V3. As an additional measure, the correct connection is determined as the connection configuration when in the first double-supply position, a voltage is detected by the first secondary-side voltage detector V1, the first primary-side voltage detector V3 and the second primary-side voltage detector V4.

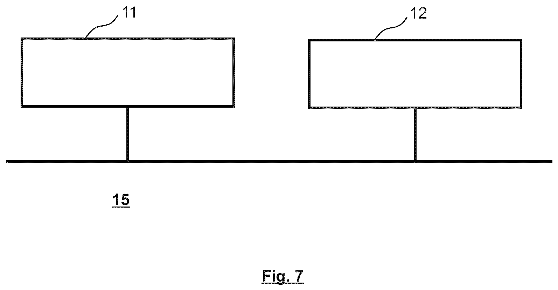

Fig. 7 shows a hardware configuration of a computer system 15. Some or all functions performed in the method disclosed herein may be performed via the computer system 15. The computer system 15 includes a processor 11 and a memory 12. The method may be implemented using program code. The memory 12 is configured to store the program code. The program code may be implemented in software or the like (such as software, firmware, or software and firmware). The memory 12 may thus store a program that may be read out and executed by the processor 11 to consequently carry out a method as described herein. For example, the processor 11 is connected, e.g. via a data connection (not shown), to the configuration controller 10. The memory 12 may be, for example, a nonvolatile or volatile semiconductor memory such as a RAM, a ROM, a flash memory, an (E)EPROM. The memory 12 may be, for example, an HDD, a floppy disc, an optical disc or the like. The processor 11 may be, for example, a central processing unit, a processing unit, a microprocessor, a microcomputer, a DSP, a single-programmed or multi-programmed processor, an ASIC, an FPGA, any combination of these, or the like.

Although particular embodiments have been shown and described, it will be understood that it is not intended to limit the claimed inventions to the preferred embodiments, and it will be obvious to those skilled in the art that various changes and modifications may be made without department from the spirit and scope of the claimed inventions. The specification and drawings are, accordingly, to be regarded in an illustrative rather than restrictive sense. The claimed inventions are intended to cover alternatives, modifications, and equivalents.

## Claims

1. A method for determining a connection configuration of a DC charging system (100), wherein the DC charging system comprises:
- a DC charging unit (UU) including:
- a first primary-side terminal (UUF1) connectible to a first power module (PM1) of a DC power supply (PU);
- a first secondary-side vehicle connection terminal (UUS1) connectible to a vehicle for providing vehicle charging power;
- a switch system (S1, S2, S3, S4) being operable to select between:
- an open position to disconnect the first primary-side terminal (UUF1) from the first secondary-side vehicle connection terminal (UUS1);
- a first single-supply position to connect the first primary-side terminal (UUF1) to the first secondary-side vehicle connection terminal (UUS1);
- a first insulation monitoring device (IMD1) provided to the first secondary-side vehicle connection terminal (UUS1);
- a first secondary-side voltage detector (V1) directly provided to the first insulation monitoring device (IMD1);
- a first primary-side voltage detector (V2, V3) directly provided to the first power module (PM1);
wherein the method comprises:
- operating the first insulation monitoring device to apply a common mode voltage at a positive DC pole (UUS1+) and/or at a negative DC pole (UUS1-) of the first vehicle connection terminal (UUS1), or operating the first power module (PM1) to apply a voltage at the first primary-side terminal (UUF1);
- operating the switch system (S1, S2, S3, S4) in a sequence between the open position and the first single-supply position, and in each switch position, detecting a voltage with each of the first secondary-side voltage detector (V1) and the first primary-side voltage detector (V2, V3); and
- determining the connection configuration from the detected voltages.

2. The method of claim 1, wherein the DC charging unit (UU) further includes:
- a second primary-side terminal (UUF2) connectible to a second power module (PM2) of the DC power supply (PU);
wherein the switch system (S1, S2, S3, S3) is further operable to select:
- a first double-supply position to connect both the first and second primary-side terminals (UUF1, UUF2) to the first secondary-side vehicle connection terminal (UUS1),
wherein the method, in operating the switch system, comprises:
- operating the switch system (S1, S2, S3, S4) in a sequence between the open position, the first single-supply position, and the first double-supply position, and in each switch position, detecting a voltage with each of the first secondary-side voltage detector (V1) and the first primary-side voltage detector (V2, V3).

3. The method of claim 2, wherein the DC charging unit (UU) further includes:
- a second primary-side voltage detector (V4, V5) directly provided to the second power module (PM2) to measure a voltage at the second power module (PM2),
wherein the method, in operating the switch system, comprises:
operating the switch system (S1, S2, S3, S4) in a sequence between the open position, the first single-supply position, and the first double-supply position, and in each switch position, detecting a voltage with each of the first secondary-side voltage detector (V1), the first primary-side voltage detector (V2, V3), and the second primary-side voltage detector (V4, V5).

4. The method according to any one of the preceding claims, wherein the DC charging system further comprises a first supply line (UUF1+, UUF1-) between the first power module (PM1) and the first primary-side terminal (UUF1), wherein the first primary-side voltage detector (V3) is arranged on a power module side of the first supply line, and wherein the DC charging system further comprises a third primary-side voltage detector (V2) arranged on a DC charging unit side of the first supply line to measure a voltage supplied to or from the DC charging unit, wherein the method further comprises detecting, in each switch position, a voltage with the third primary-side voltage detector (V2).

5. The method according to claim 3 or claim 4 where dependent on claim 3, wherein the DC charging system further comprises a second supply line (UUF2+, UUF2-) between the second power module (PM2) and the second primary-side terminal (UUF2), wherein the second primary-side voltage detector (V4) is arranged on a power module side of the second supply line, and wherein the DC charging system further comprises a fourth primary-side voltage detector (V5) arranged on a DC charging unit side of the second supply line to measure a voltage supplied to or from the DC charging unit, wherein the method further comprises detecting, in each switch position, a voltage with the fourth primary-side voltage detector (V5).

6. The method according to any one of the preceding claims, wherein the DC charging unit (UU) further includes a second secondary-side vehicle connection terminal (UUS2) connectible to a vehicle for providing vehicle charging power, wherein the DC charging system further comprises a second insulation monitoring device (IMD1) provided to the second secondary-side vehicle connection terminal (UUS2), and a second secondary-side voltage detector (V6) ) to measure a voltage supplied to or from the second insulation monitoring device (IMD2), and wherein the method further comprises operating the second insulation monitoring device (IMD2) to apply a common mode voltage at a positive DC pole and/or at a negative DC pole of the second secondary-side vehicle connection terminal (UUS2), and detecting, in each switch position, a voltage with the second secondary-side voltage detector (V6).

7. The method according to any one of the preceding claims, wherein the connection configuration includes a correct connection.

8. The method according to claim 7, wherein the method further comprises determining the correct connection as the connection configuration when:
- in the open position of the switch, a voltage is only detected by the first secondary-side voltage detector (V1); and
- in the first single-supply position, a voltage is only detected by the first secondary-side voltage detector (V1) and the first primary-side voltage detector (V3).

9. The method according to claims 7 and 8 where directly or indirectly dependent on claim 3, wherein the method further comprises determining the correct connection as the connection configuration when:
- in the first double-supply position, a voltage is detected by the first secondary-side voltage detector (V1), the first primary-side voltage detector (V3) and the second primary-side voltage detector (V4).

10. The method according to any one of the preceding claims, wherein the connection configuration includes a primary-side pole swapped connection.

11. The method according to any one of the preceding claims, wherein the connection configuration includes a missing ground connection.

12. A DC charging system (100) comprising:
- at least one DC charging unit (UU) including:
- a first primary-side terminal (UUF1) connectible to a first power module (PM1) of a DC power supply (PU);
- a second primary-side terminal (UUF2) connectible to a second power module (PM2) of the DC power supply (PU);
- a switch system (S1, S2, S3, S4) being operable to select between:
- an open position to disconnect the first primary-side terminal (UUF1) from the first secondary-side vehicle connection terminal (UUS1);
- a first single-supply position to connect the first primary-side terminal (UUF1) to the first secondary-side vehicle connection terminal (UUS1);
- a first insulation monitoring device (IMD1) provided to the first secondary-side vehicle connection terminal (UUS1);
- a first secondary-side voltage detector (V1) directly provided to the first insulation monitoring device (IMD1);
- a first primary-side voltage detector (V2, V3) directly provided to the first power module (PM1);
- a configuration controller (10) configured to:
- operate the first insulation monitoring device to apply a common mode voltage at a positive DC pole (UUS1+) and/or at a negative DC pole (UUS1-) of the first vehicle connection terminal (UUS1), or operate the first power module (PM1) to apply a voltage at the first primary-side terminal (UUF1);
- operate the switch system (S1, S2, S3, S4) in a sequence between the open position and the first single-supply position, and in each switch position, detect a voltage with each of the first secondary-side voltage detector (V1) and the first primary-side voltage detector (V2, V3); and
- determine the connection configuration from the detected voltages.

13. A charging infrastructure (200), comprising:
- at least one DC charging system (100) according to claim 12; and
- the DC power supply (PU) comprising the first and second power modules (PM1, PM2).

14. The charging infrastructure (200) according to claim 13, including two or more DC charging units (UU) interconnected via one or more secondary-side DC power sharing terminals (UUS4, UUS5).

15. A computer system (15), comprising:
- a memory (11) configured to store program code; and
- a processor (12) configured to execute the program code to implement a method according to any one of claims 1 through 11.
